# EUROPÄISCHE PATENTSCHRIFT

(11) **EP 3 369 139 B1**
(45) Veröffentlichungstag und Bekanntmachung des Hinweises auf die Patenterteilung: **24.02.2021**
(21) Anmeldenummer: 16781293.2
(22) Anmeldetag: 12.10.2016
(51) Int. Cl.: H01R 9/22, H01R 31/02, H01R 9/24, H02M 7/00, H01R 31/06, H01R 31/08

(54) **ANSCHLUSSEINHEIT FÜR EIN ELEKTROGERÄT, ELEKTROGERÄTESYSTEM UND VERFAHREN ZUR HERSTELLUNG**
CONNECTION UNIT FOR AN ELECTRIC APPLIANCE, ELECTRIC APPLIANCE SYSTEM, AND PRODUCTION METHOD
UNITÉ DE BRANCHEMENT POUR UN APPAREIL ÉLECTRIQUE, SYSTÈME D'APPAREILS ÉLECTRIQUES ET PROCÉDÉ DE FABRICATION

(30) Priorität: 27.10.2015 DE 102015013902
(43) Veröffentlichungstag der Anmeldung: 05.09.2018
(73) Patentinhaber: SEW-Eurodrive GmbH & Co, 76646 Bruchsal (DE)
(72) Erfinder: RITZ, Stefanie, 69168 Wiesloch (DE); OTT, Jürgen, 76706 Dettenheim (DE)
(86) Internationale Anmeldenummer: PCT/EP2016/025113
(87) Internationale Veröffentlichungsnummer: WO 2017/071815

(56) Entgegenhaltungen:
- EP-A2- 1 065 768
- DE-A1- 10 325 956
- US-A1- 2015 064 989

## Beschreibung

Die Erfindung betrifft ein Elektrogerätesystem und ein Verfahren zur Herstellung von zwei Varianten einer Anschlusseinheit.

Aus der DE 103 25 956 B4 ist ein Umrichtersystem bekannt DE10325956 B4 ist als nächstliegender Stand der Technik des Anspruch 1 angesehen und offenbart ein Elektrogerätesystem mit zwei Elektrogeräte, Verbindungschienen und zwei gleichartige Anschlusseinheiten.

Aus der EP 1 065 768 A2 ist als nächstliegender Stand der Technik des Anspruchs 7 eine Anschlusseinheit für ein Elektrogerät bekannt EP 1 065 768 A2 offenbart ein Verfahren zur Herstellung einer Anschlusseinheit für ein Elektrogerätesystem.

Der Erfindung liegt daher die Aufgabe zugrunde, ein Elektrogerätesystem und ein Verfahren zur Herstellung weiterzubilden, wobei der Umweltschutz verbessert werden soll.

Erfindungsgemäß wird die Aufgabe bei dem Elektrogerätesystem nach den in Anspruch 1 angegebenen Merkmalen und bei dem Verfahren zur Herstellung nach den in Anspruch 7 angegebenen Merkmalen gelöst.

Von Vorteil ist dabei, dass ein Elektrogerätesystem, aufweisend verschiedenartige Elektrogeräte, deren Spannungseingänge und/oder Spannungsausgänge elektrisch leitend miteinander verbindbar sind, einen Baukasten von Anschlusseinheiten aufweist. Mittels der Anschlusseinheiten sind die Elektrogeräte miteinander und/oder mit einer externen Drehstromversorgung und/oder mit einer zu speisenden Maschine verbindbar. Vorteilhafterweise weist der Baukasten von Anschlusseinheiten ein Aufnahmeteil auf, das für alle Varianten der Anschlusseinheiten identisch ausgeführt ist. Somit ist die Zahl der Bauteile reduzierbar. Der Umweltschutz ist verbessert.

Bei einer vorteilhaften Ausgestaltung ist das erste Elektrogerät als Versorgungsmodul ausgeführt und weist einen Gleichrichter auf, wobei das zweite Elektrogerät als Achsmodul ausgeführt ist und einen Wechselrichter aufweist, wobei der Spannungsausgang des Gleichrichters, insbesondere Zwischenkreisspannungsanschluss, mit zwei jeweiligen Anschlussmitteln, insbesondere Stromschienen, der ersten Anschlusseinheit elektrisch leitend verbunden ist und der Spannungseingang des Wechselrichters, insbesondere Zwischenkreisspannungsanschluss, mit zwei jeweiligen Anschlussmitteln, insbesondere Stromschienen, der zweiten Anschlusseinheit elektrisch leitend verbunden ist, wobei jeweils ein Anschlussmittel der ersten Anschlusseinheit mit jeweils einem Anschlussmittel der zweiten Anschlusseinheit mittels einer Verbindungsschiene verbunden ist. Von Vorteil ist dabei, dass das Elektrogerätesystem als Umrichtersystem ausführbar ist. Vorteilhafterweise weist das Umrichtersystem einen gemeinsamen Gleichspannungszwischenkreis für alle Module, insbesondere Versorgungsmodul und Achsmodul, auf. Die Gleichspannungseingänge und/oder Gleichspannungsausgänge der Module sind mittels der Anschlussmittel der Anschlusseinheiten und der Verbindungsschienen miteinander verbindbar.

Bei einer vorteilhaften Ausgestaltung weist das Elektrogerätesystem zwei Verbindungschienen und ein zwischen den beiden Verbindungschienen angeordnetes Isoliermittel auf, wobei die Verbindungsschienen das Isoliermittel jeweils berühren, insbesondere wobei die Verbindungschienen elektrisch voneinander isoliert angeordnet sind mittels des Isoliermittels. Von Vorteil ist dabei, dass der schichtartige Aufbau der Verbindungsschienen mit dem Isoliermittel eine Reduzierung des elektrischen Durchleitungswiderstandes ermöglicht. Dieser schichtartige Aufbau wirkt als Filterkondensator. Somit sind Schwingungen beziehungsweise Schwankungen der Spannung in den Verbindungsschienen reduzierbar. Somit ist der Umweltschutz verbessert.

Bei einer vorteilhaften Ausgestaltung weist die erste Anschlusseinheit drei Anschlussmittel, insbesondere Laschenteile, auf, wobei jeweils eine Phase einer Drehstromversorgung mit einem jeweiligen Spannungseingang des Versorgungsmoduls mittels eines jeweiligen Anschlussmittels verbunden ist. Von Vorteil ist dabei, dass das Versorgungsmodul verbindbar ist mit einer dreiphasigen Drehstromversorgung mittels der Anschlusseinheit.

Bei einer vorteilhaften Ausgestaltung weist die zweite Anschlusseinheit drei Anschlussmittel, insbesondere Laschenteile, auf, wobei jeweils eine Phase der von dem Wechselrichter erzeugten dreiphasigen Wechselspannung mittels jeweils eines Anschlussmittels mit einem jeweiligen Spannungseingang einer Maschine, insbesondere eines Elektromotors, verbunden ist. Von Vorteil ist dabei, dass die Maschine speisbar ist aus dem Achsmodul. Vorteilhafterweise ist die Maschine steuerbar mittels des Achsmoduls, indem ein Drehstrom mit einer vorgegebenen Frequenz von dem Achsmodul erzeugbar ist.

Bei einer vorteilhaften Ausgestaltung weist das Aufnahmeteil zwei zweite Aufnahmeabschnitte für zwei Anschlussmittel, insbesondere Laschenteile, auf, wobei in den zweiten Aufnahmeabschnitten des zweiten Aufnahmeteils Anschlussmittel aufgenommen sind zur elektrisch leitenden Verbindung mit einem Bremswiderstand des Versorgungsmoduls. Von Vorteil ist dabei, dass mittels des Bremswiderstandes die Spannung im Spannungszwischenkreis bei generatorischem Betrieb des Umrichtersystems reduzierbar ist, indem elektrische Energie in Wärmeenergie umwandelbar ist.

Bei einer vorteilhaften Ausgestaltung weist das Umrichtersystem zumindest ein Verbindungsteil auf, wobei das Verbindungsteil mittels Buchsen, die mit dem jeweiligen Aufnahmeteil formschlüssig verbunden sind, das Versorgungsmodul und/oder das Achsmodul mit einer Niederspannungsversorgung elektrisch leitend verbindet. Von Vorteil ist dabei, dass die Module, insbesondere Versorgungsmodul und/oder Achsmodul, verbindbar sind mit einer Niederspannungsversorgung und/oder einer Signalverbindung zur Übertragung von Steuerbefehlen. Somit sind zusätzliche Kabel für die Niederspannungsversorgung und/oder Signalverbindung einsparbar. Der Umweltschutz ist verbessert.

Bei einer vorteilhaften Ausgestaltung sind die jeweiligen Niederspannungseingänge des Versorgungsmoduls und des Achsmoduls mittels der Buchsen und des Verbindungsteils elektrisch leitend miteinander verbunden. Von Vorteil ist dabei, dass eine sichere elektrisch leitende Verbindung herstellbar ist.

Wichtige Merkmale einer Anschlusseinheit für ein vorgenanntes Elektrogerät sind, dass
die Anschlusseinheit ein elektrisch isolierendes Aufnahmeteil, aufweisend einen ersten Aufnahmeabschnitt, einen zweiten Aufnahmeabschnitt und zumindest ein elektrisch leitendes Anschlussmittel, insbesondere eine Stromschiene, aufweist,
wobei das Aufnahmeteil mittels der ersten und zweiten Aufnahmeabschnitte zur Aufnahme von Anschlussmitteln eingerichtet ist,
wobei ein Anschlussmittel in dem ersten Aufnahmeabschnitt aufgenommen ist.

Von Vorteil ist dabei, dass die Anschlussmittel lösbar mit dem jeweiligen Aufnahmeabschnitt verbindbar sind. Somit ist die Anschlusseinheit mit Anschlussmitteln bestückbar oder nicht, je nachdem welche Anschlussmittel für das Elektrogerät erforderlich sind. Somit ist die Anschlusseinheit für einen Baukasten für verschiedene Elektrogeräte verwendbar.

Vorteilhafterweise weist der Baukasten wiederverwendbare Teile für die Anschlusseinheit auf. Somit ist die Zahl der Bauteile in dem Baukasten reduzierbar und der Umweltschutz ist verbessert.

Erfindungsgemäß ist in dem zweiten Aufnahmeabschnitt kein Anschlussmittel aufgenommen. Von Vorteil ist dabei, dass identisch ausgeführte Aufnahmeteile für verschiedene Ausführungen der Anschlusseinheiten verwendbar sind. Dabei sind je nach Ausführung der Anschlusseinheiten Anschlussmittel in den Aufnahmeabschnitten aufgenommen oder nicht.

Bei einer vorteilhaften Ausgestaltung sind die ersten Aufnahmeabschnitte jeweils voneinander beabstandet, wobei die zweiten Aufnahmeabschnitte jeweils voneinander beabstandet sind, wobei die ersten Aufnahmeabschnitte und die zweiten Aufnahmeabschnitte jeweils voneinander beabstandet sind. Von Vorteil ist dabei, dass das elektrisch isolierend ausgeführte Aufnahmeteil als Isoliermittel verwendbar ist für die in den Aufnahmeabschnitten aufgenommenen Anschlussmittel.

Bei einer vorteilhaften Ausgestaltung sind Anschlussmittel voneinander beabstandbar mittels des Aufnahmeteils, insbesondere elektrisch isoliert anordenbar. Von Vorteil ist dabei, dass kein zusätzliches Isoliermittel erforderlich ist. Somit ist die Zahl der Bauteile reduzierbar und der Umweltschutz ist verbessert.

Bei einer vorteilhaften Ausgestaltung ist das Anschlussmittel lösbar mit dem Aufnahmeteil verbunden, insbesondere formschlüssig und/oder kraftschlüssig verbunden. Von Vorteil ist dabei, dass die Aufnahmeeinheit anpassbar ist an das Elektrogerät. Vorteilhafterweise ist die Aufnahmeeinheit wiederverwendbar für ein andersartiges Elektrogerät, indem die Anschlussmittel nachrüstbar und/oder entfernbar sind.

Bei einer vorteilhaften Ausgestaltung ist das Anschlussmittel mittels eines Schraubteils mit dem Aufnahmeteil schraubverbunden. Von Vorteil ist dabei, dass das Anschlussmittel sicher und lösbar verbindbar ist mit dem Aufnahmeteil.

Bei einer vorteilhaften Ausgestaltung verbindet das Anschlussmittel einen Kabelschuh und/oder eine Verbindungsschiene elektrisch leitend mit einem elektrischen Anschlusselement, insbesondere einem Spannungseingang und/oder einem Spannungsausgang, des Elektrogerätes. Von Vorteil ist dabei, dass keine zusätzlichen Kabel zur Verbindung des Elektrogerätes mit dem Kabelschuh oder der Verbindungsschiene erforderlich sind. Somit sind Bauteile einsparbar und der Umweltschutz ist verbessert.

Bei einer vorteilhaften Ausgestaltung weist das Anschlussmittel eine Gewindebohrung auf, mit der ein Schraubteil schraubverbindbar ist zur lösbaren elektrisch leitenden Verbindung des Kabelschuhs und/oder der Verbindungsschiene mit dem Anschlussmittel. Von Vorteil ist dabei, dass eine sichere elektrisch leitende mechanische Verbindung ausführbar ist.

Bei einer vorteilhaften Ausgestaltung weist die Anschlusseinheit eine Buchse auf, die stoffschlüssig mit dem Aufnahmeteil verbunden ist, insbesondere umspritzt ist, insbesondere wobei die Buchse aus elektrisch leitfähigen Material hergestellt ist. Von Vorteil ist dabei, dass jede Anschlusseinheit die Buchse aufweist. Die Buchse ist in einfacher Art und Weise verliersicher mit dem Aufnahmeteil verbindbar.

Bei einer vorteilhaften Ausgestaltung weist die Anschlusseinheit zwei Anschlussmittel und ein zwischen den beiden Anschlussmitteln angeordnetes Isoliermittel auf, wobei die Anschlussmittel das Isoliermittel jeweils berühren, wobei die Anschlussmittel in dem Aufnahmeteil aufgenommen sind, insbesondere wobei die Anschlussmittel elektrisch voneinander isoliert angeordnet sind mittels des Isoliermittels. Von Vorteil ist dabei, dass der schichtartige Aufbau der Anschlussmittel mit dem Isoliermittel eine Reduzierung des elektrischen Durchleitungswiderstandes ermöglicht. Dieser schichtartige Aufbau wirkt als Filterkondensator. Somit sind Schwingungen beziehungsweise Schwankungen der Spannung in den Anschlussmitteln reduzierbar. Somit ist der Umweltschutz verbessert.

Bei einer vorteilhaften Ausgestaltung ist das Aufnahmeteil als Kunststoffteil ausgeführt, insbesondere als Kunststoffspritzgussteil. Von Vorteil ist dabei, dass das Aufnahmeteil in einfacher Art und Weise herstellbar ist.

Bei einer vorteilhaften Ausgestaltung sind die Aufnahmeabschnitte als Ausnehmungen in dem Aufnahmeteil ausgeführt. Von Vorteil ist dabei, dass die Aufnahmeabschnitte in einfacher Art und Weise ausführbar sind. Vorteilhafterweise sind die Ausnehmungen in einem Arbeitsgang mit dem Aufnahmeteil herstellbar mittels eines Spritzgussverfahrens.

Bei einer vorteilhaften Ausgestaltung ist das Anschlussmittel als Blechteil, insbesondere Stanzbiegeteil, ausgeführt. Von Vorteil ist dabei, dass die Anschlussmittel einen großen Querschnitt aufweisen und dadurch einen geringeren elektrischen Widerstand aufweisen als beispielsweise elektrische Verbindungskabel.

Bei einer vorteilhaften Ausgestaltung weist die Anschlusseinheit ein Deckelteil auf, wobei das Deckelteil lösbar mit dem Aufnahmeteil verbunden ist, insbesondere mittels einen Schraubteils schraubverbunden, wobei die Stromschiene begrenzt ist mittels des Deckelteils und des Aufnahmeteils. Von Vorteil ist dabei, dass die Stromschiene zumindest teilweise aufnehmbar ist in dem Deckelteil. Vorteilhafterweise ist das Deckelteil elektrisch isolierend ausführbar, insbesondere als Kunststoffteil. Somit ist ein Berührschutz geschaffen für die Stromschiene mittels des Deckelteils.

Bei einer vorteilhaften Ausgestaltung ist die Stromschiene zumindest teilweise zwischen dem Deckelteil und dem Aufnahmeteil angeordnet und/oder gehalten von dem Deckelteil und dem Aufnahmeteil. Von Vorteil ist dabei, dass die Stromschiene lösbar verbunden ist mit dem Aufnahmeteil mittels des Deckelteils.

Bei einer vorteilhaften Ausgestaltung weist das Deckelteil eine Ausnehmung auf, durch welche die Stromschiene zumindest teilweise hindurchgeführt ist. Von Vorteil ist dabei, dass die Stromschiene elektrisch leitend verbindbar ist mit einem Spannungseingang und/oder Spannungsausgang des Elektrogeräts.

Vorteilhafterweise weist das Deckelteil zwei voneinander beabstandete Ausnehmungen auf, wobei durch jede Ausnehmung jeweils eine Stromschiene teilweise hindurchgeführt ist. Somit sind die Stromschienen elektrisch voneinander isolierbar mittels des Deckelteils.

Wichtige Merkmale der Erfindung bei dem Verfahren zur Herstellung von zwei Varianten einer Anschlusseinheit für ein Elektrogerätesystem nach einem der auf die Elektrogerätesystem gerichteten Ansprüche, aus einem Baukasten mit folgenden Teilen:
- ein Aufnahmeteil,
- ein Deckelteil, aufweisend zwei Ausnehmungen,
- zwei Stromschienen,
- ein Isoliermittel und
- zumindest ein Laschenteil,
wobei das Aufnahmeteil zumindest einen ersten Aufnahmeabschnitt und einen zweiten Aufnahmeabschnitt für Laschenteile und Aufnahmeabschnitte, insbesondere Ausnehmungen, für die Stromschienen aufweist,
wobei zur Herstellung einer ersten Variante der Anschlusseinheit:
- in einem ersten Verfahrensschritt das Isoliermittel zwischen den Stromschienen angeordnet, insbesondere formschlüssig verbunden, wird, so dass die Stromschienen elektrisch voneinander isoliert werden und aus den Stromschienen und dem Isoliermittel eine vorkomplettierte Einheit gebildet wird,
- in einem zweiten Verfahrensschritt die vorkomplettierte Einheit in das Deckelteil eingelegt wird, wobei ein jeweiliger Laschenabschnitt einer Stromschiene der Einheit durch eine jeweilige Ausnehmung geführt wird,
- in einem dritten Verfahrensschritt das Deckelteil lösbar mit dem Aufnahmeteil verbunden wird, insbesondere mittels eines Schraubteils schraubverbunden, und
- in einem vierten Verfahrensschritt das Laschenteil in den ersten Aufnahmeabschnitt eingeführt wird und formschlüssig mit dem Aufnahmeteil verbunden wird, insbesondere mittels eines Schraubteils schraubverbunden,
wobei zur Herstellung einer zweiten Variante der Anschlusseinheit, zusätzlich zu dem ersten bis vierten Verfahrensschritt, in einem fünften Verfahrensschritt ein weiteres Laschenteil in den zweiten Aufnahmeabschnitt eingeführt wird und formschlüssig mit dem Aufnahmeteil verbunden wird, insbesondere mittels eines Schraubteils schraubverbunden.

Von Vorteil ist dabei, dass zwei verschiedene Varianten der Anschlusseinheit mit einem Verfahren herstellbar sind, indem ein Verfahrensschritt mehr oder weniger ausgeführt wird. Vorteilhafterweise weist der Baukasten wiederverwendbare Teile für die Anschlusseinheit auf. Somit ist die Zahl der Bauteile in dem Baukasten reduzierbar und der Umweltschutz ist verbessert.

Weitere Vorteile ergeben sich aus den Unteransprüchen. Die Erfindung ist auf die Merkmalskombination der Ansprüche beschränkt.

Die Erfindung wird nun anhand von Abbildungen näher erläutert:
In der Figur 1 ist ein erfindungsgemäßes Elektrogerätesystem, insbesondere Umrichtersystem, in Schrägansicht gezeigt.
Figur 2 zeigt das erfindungsgemäße Elektrogerätesystem in Draufsicht.
In der Figur 3 ist eine Anschlusseinheit in Draufsicht gezeigt.
In der Figur 4 ist die Anschlusseinheit in Schrägansicht dargestellt.
Figur 5 zeigt die Rückseite der Anschlusseinheit in Draufsicht.
Figur 6 zeigt die Rückseite der Anschlusseinheit in Schrägansicht.
In der Figur 7 ist die Rückseite der Anschlusseinheit in einer weiteren Schrägansicht dargestellt, wobei ein Deckelteil der Anschlusseinheit entfernt wurde.
In der Figur 8 ist ein Ausschnitt eines Achsmoduls des Umrichtersvstems mit einer zweiten Ausführungsform der Anschlusseinheit in Schrägansicht dargestellt.
Figur 9 zeigt die zweite Ausführungsform der Anschlusseinheit in Schrägansicht.

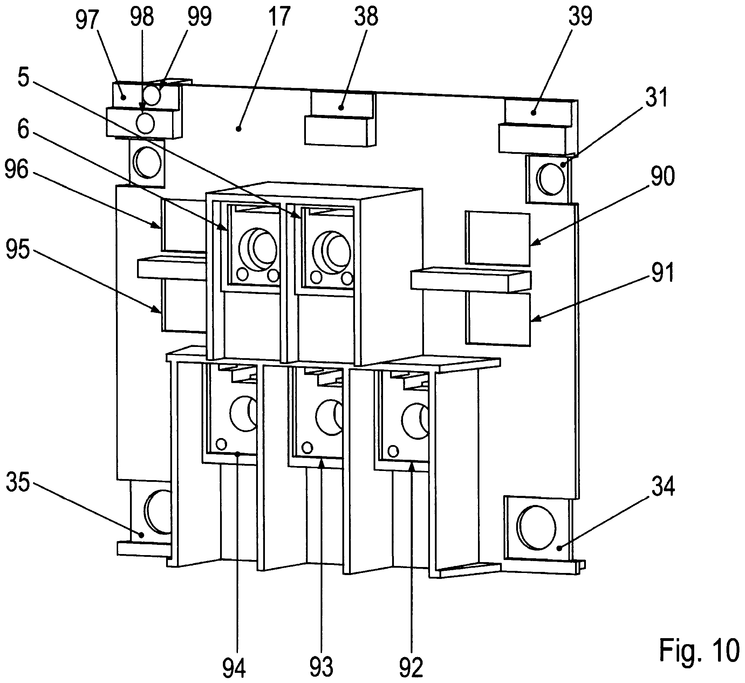

In Figur 10 ist ein Aufnahmeteil der Anschlusseinheit in Schrägansicht gezeichnet.

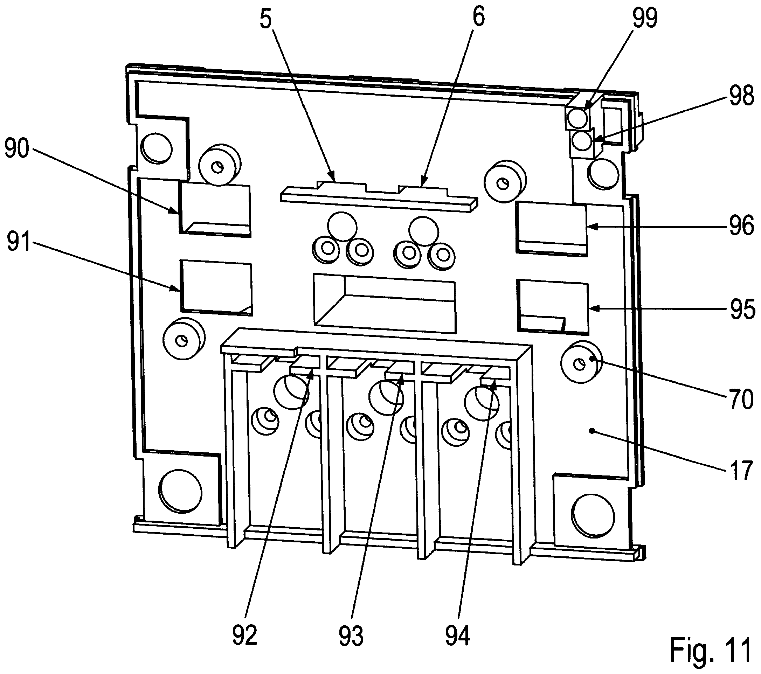

In der Figur 11 ist die Rückseite des Aufnahmeteils in Schrägansicht dargestellt.

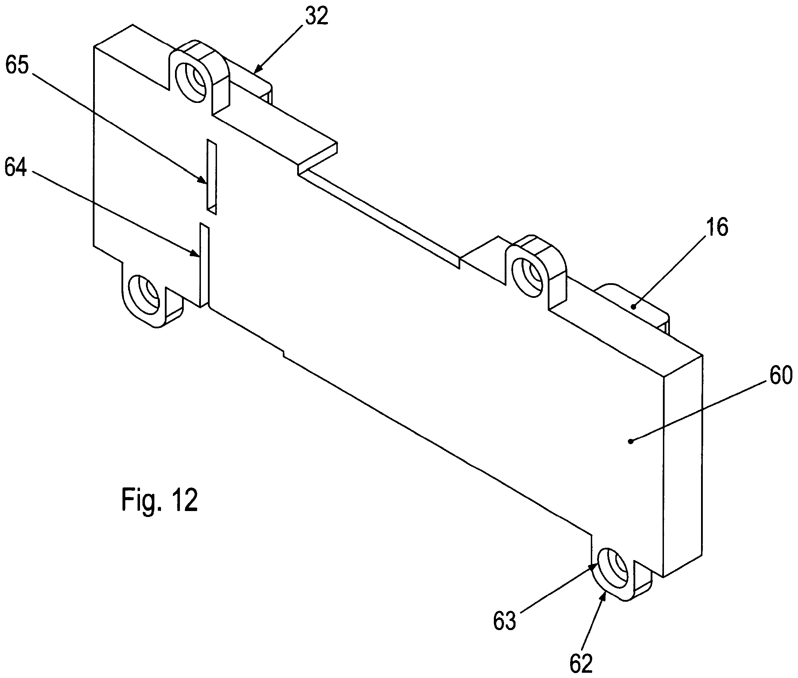

Figur 12 zeigt das Deckelteil in Schrägansicht.

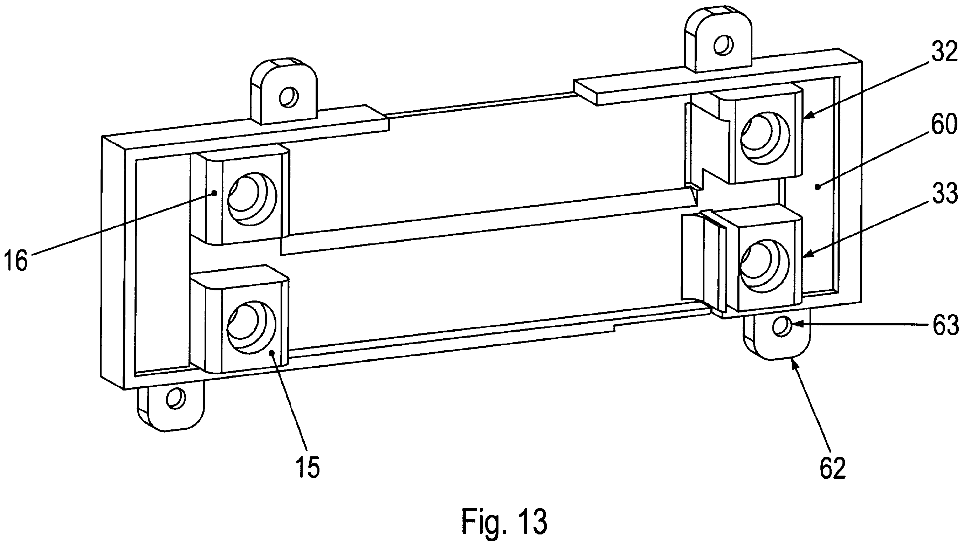

Figur 13 zeigt die dem Aufnahmeteil zugewandte Seite des Deckelteils, in dem zwei Stromschienen der Anschlusseinheit angeordnet sind, in Schrägansicht.
In der Figur 14 ist eine erste Stromschiene in Schrägansicht dargestellt.
In der Figur 15 ist eine zweite Stromschiene in Schrägansicht gezeichnet.
Figur 16 zeigt ein erstes Laschenteil der Anschlusseinheit in Schrägansicht.
Figur 17 zeigt ein viertes Laschenteil der erfindungsgemäßen in Schrägansicht.
In der Figur 18 ist ein Isoliermittel der Anschlusseinheit in Schrägansicht dargestellt.
In der Figur 19 ist die Anordnung der Stromschienen, Laschenteile und des Isoliermittels ohne das Aufnahmeteil in Schrägansicht dargestellt.
Figur 20 zeigt die Anordnung der Stromschienen, Laschenteile und des Isoliermittels ohne das Aufnahmeteil in einer weiteren Schrägansicht.

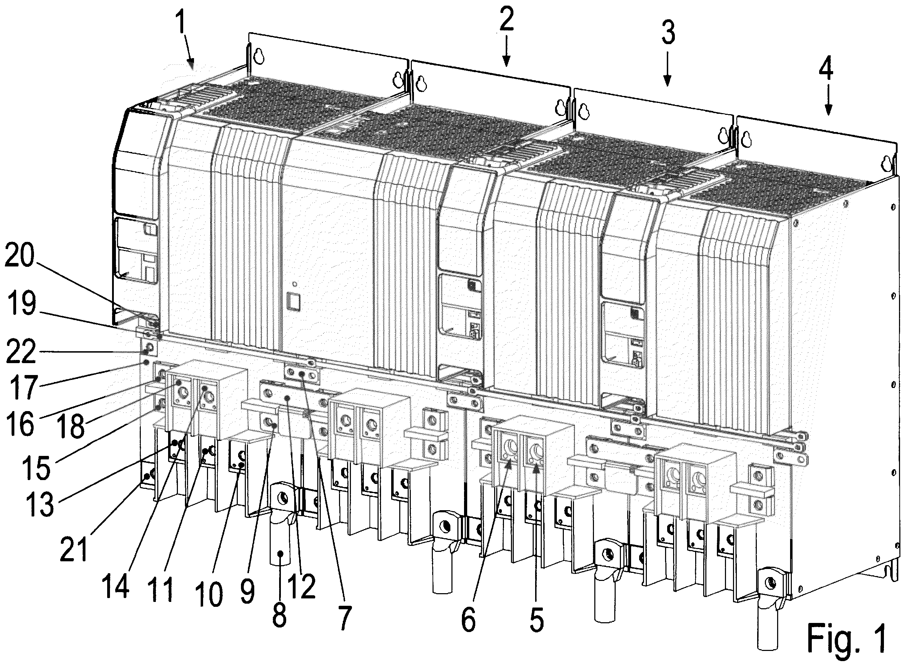

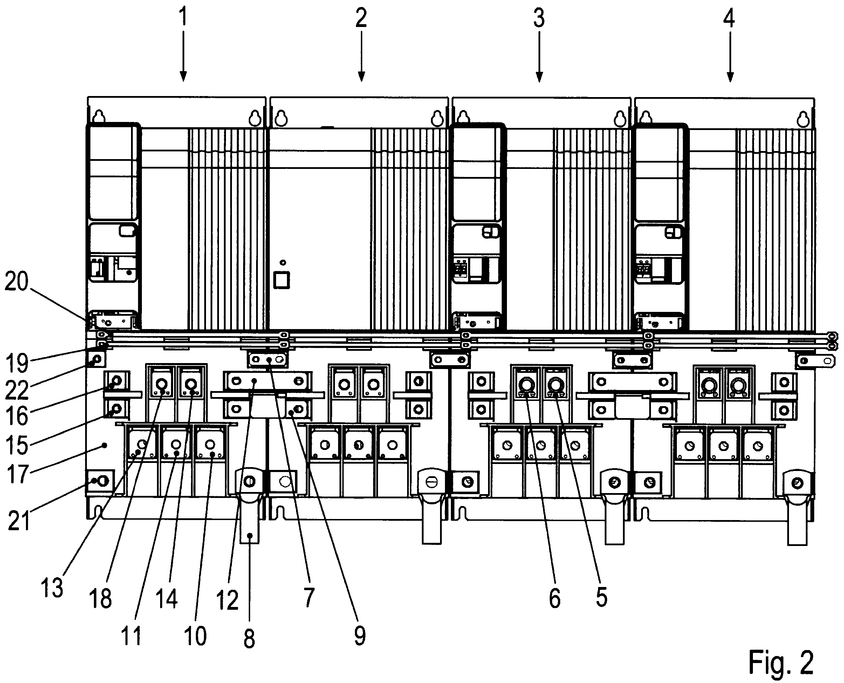

Das in den Figuren 1 und 2 dargestellte erfindungsgemäße Elektrogerätesystem, insbesondere Umrichtersystem, weist vier Module beziehungsweise Elektrogeräte auf, insbesondere ein Versorgungsmodul 1 und drei Achsmodule (2, 3, 4). Jedes der Module weist jeweils eine erfindungsgemäße Anschlusseinheit (30, 130) auf.

Das Versorgungsmodul 1 weist eine erste Anschlusseinheit 30 auf. Die Achsmodule (2, 3, 4) weisen jeweils eine zweite Anschlusseinheit 130 auf.

Mittels der jeweiligen Anschlusseinheit (30, 130) sind Spannungseingänge und Spannungsausgänge der jeweiligen Module elektrisch leitend miteinander verbindbar. Mittels der jeweiligen Anschlusseinheit (30, 130) sind die Module an eine externe Spannungsquelle anschließbar und/oder an eine Maschine, insbesondere einen umrichtergespeisten Elektromotor, anschließbar.

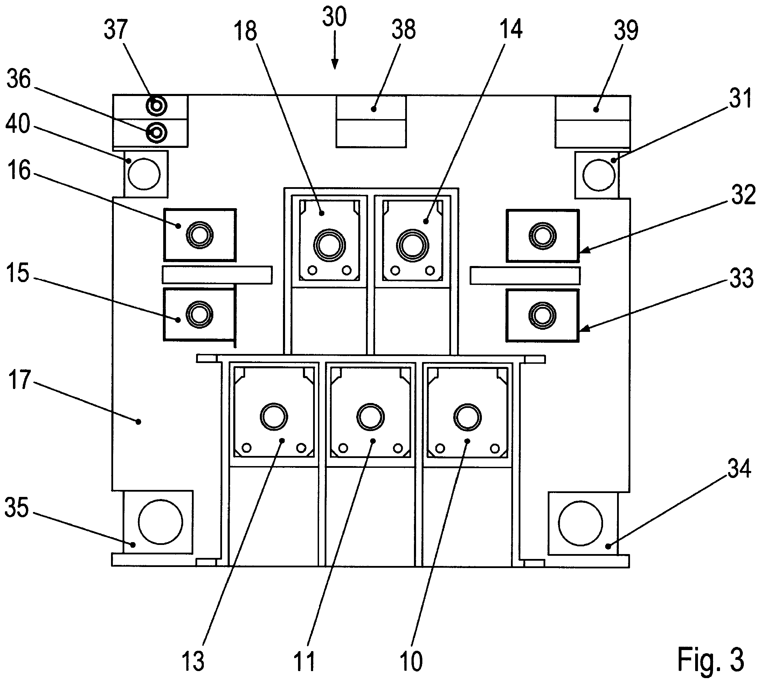

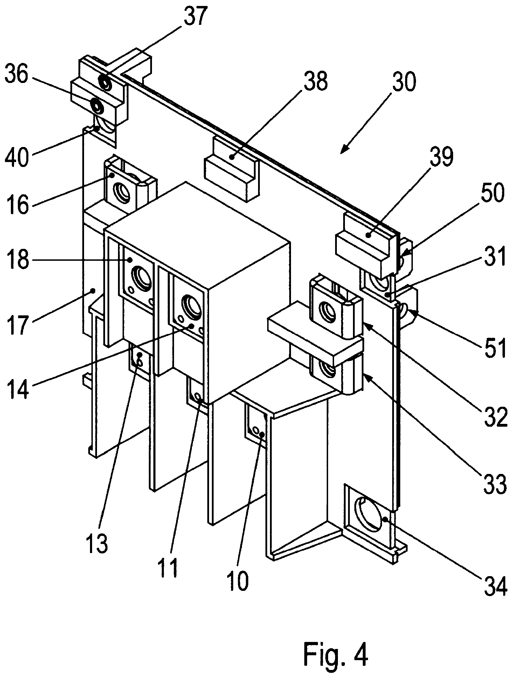

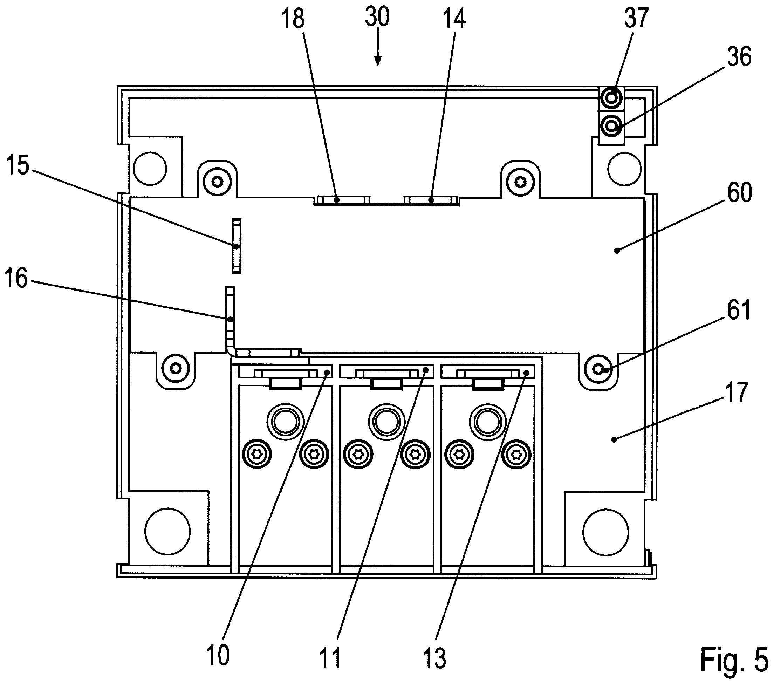

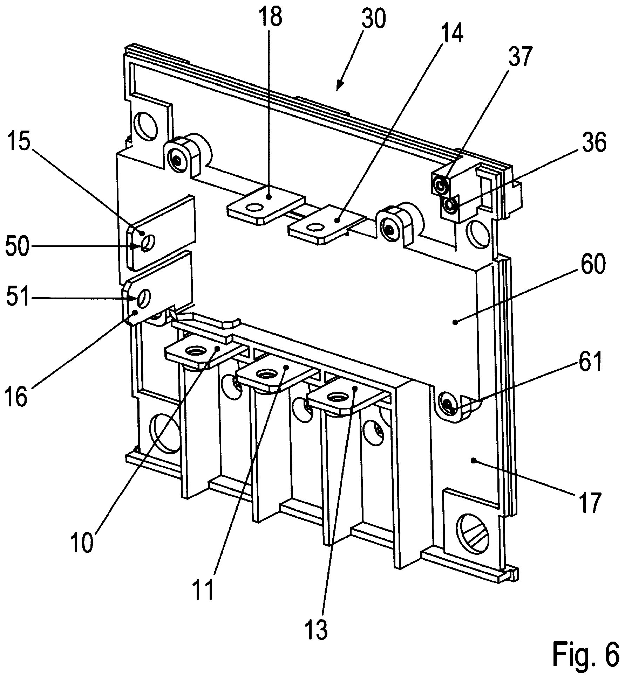

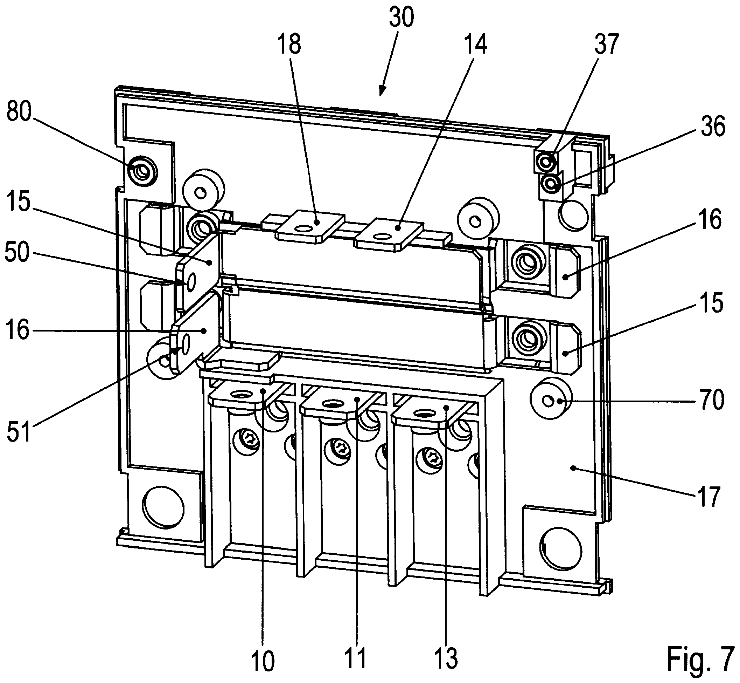

Wie in den Figuren 3 bis 7 gezeigt, weist die Anschlusseinheit (30) ein elektrisch isolierend ausgeführtes Aufnahmeteil 17 und metallische Anschlussmittel auf, insbesondere eine erste und zweite Stromschiene (15, 16) und/oder Laschenteile (10, 11, 13, 14, 18) und/oder Buchsen (36, 37, 80), welche zur Verbindung mit einem Kabelschuh und/oder einer Verbindungsschiene (9, 12) und/oder einem Verbindungsteil (7, 19, 20) vorgesehen sind. Auf die an der Oberseite der Anschlusseinheit 1 nach außen hervor ragende Oberfläche des jeweiligen metallischen Anschlussmittels wird jeweils ein Kabelschuh und/oder eine Verbindungschiene (9, 12) und/oder ein Verbindungsteil (7, 19, 20) aufgelegt und schraubverbunden. Dazu weist jedes Anschlussmittel eine Ausnehmung (200, 210), insbesondere Gewindebohrung, auf.

Dabei ist für jedes der metallischen Teile ein entsprechend geformter Aufnahmeabschnitt (5, 6, 92, 93, 94) und/oder eine Ausnehmung (90, 91, 95, 96, 98, 99) in dem Aufnahmeteil 17 vorgesehen.

Das erste Aufnahmeteil 17 der ersten Anschlusseinheit 30 ist identisch ausgeführt zu dem zweiten Aufnahmeteil 17 der zweiten Anschlusseinheit 130.

Vorzugsweise sind die Anschlussmittel in dem Aufnahmeteil 17 beabstandet voneinander angeordnet.

Das Aufnahmeteil 17 ist aus Kunststoff ausgeführt, vorzugsweise als Kunststoffspritzgussteil. Die Buchsen (36, 37, 80) sind stoffschlüssig verbunden mit dem Aufnahmeteil 17. Vorzugsweise sind die Buchsen (36, 37, 80) umspritzt von dem Aufnahmeteil 17. Hierzu werden die Buchsen (36, 37, 80) bei der Herstellung des Kunststoffspritzgusses in einem Werkzeug angeordnet und danach der Kunststoff eingespritzt in das Werkzeug.

Mittels der Buchsen (36, 37) ist eine Niederspannungsversorgung anschließbar an einen Niederspannungseingang des jeweiligen Moduls. Mittels Verbindungsteilen (19, 20), die elektrisch leitend mit je einer Buchse (36, 37) zweier Anschlusseinheiten (30, 130) verbunden sind, insbesondere lösbar verbunden, sind mehrere Module des Umrichtersystems mit Niederspannung versorgbar. Die Verbindungsteile (19, 20) erstrecken sich entlang der vollen Breite des Aufnahmeteils 17. Die Verbindungsteile (19, 20) sind aufgelagert mittels zumindest eines Auflagerungsabschnitts (38, 39, 97) auf dem Aufnahmeteil 17.

Die Stromschienen (15, 16) und/oder Laschenteile (10, 11, 13, 14, 18) sind formschlüssig und/oder kraftschlüssig mit dem Aufnahmeteil 17 verbunden. Dazu weist die Anschlusseinheit 30 ein Deckelteil 60 auf. Das Deckelteil 60 ist lösbar verbunden, insbesondere mittels eines Schraubteils 61, mit dem Aufnahmeteil 17. Dazu weist das Aufnahmeteil 17 einen Vorsprung 70 auf, in dem eine Gewindebohrung angeordnet ist zur Verbindung mit dem Schraubteil 61. Das Deckelteil 60 weist eine Lasche 62 mit einer Ausnehmung 63 auf, durch die das Schraubteil 61 teilweise hindurchgeführt ist.

Die Stromschienen (15, 16) sind begrenzt von dem Deckelteil 60 und dem Aufnahmeteil 17, insbesondere abschnittsweise zwischen dem Deckelteil 60 und dem Aufnahmeteil 17 angeordnet, insbesondere abschnittsweise in dem Deckelteil 60 aufgenommen.

Das Deckelteil 60 weist jeweils eine Ausnehmung (64, 65) für jede Stromschiene (15, 16) auf, durch die die jeweilige Stromschiene (15, 16) zumindest teilweise hindurchgeführt ist.

Das Deckelteil 60 ist aus elektrisch isolierendem Material, insbesondere Kunststoff, hergestellt, insbesondere als Kunststoffspritzgussteil.

Die Anschlusseinheit (30) ist lösbar verbunden, insbesondere schraubverbunden, mit einem Gehäuseteil 100 eines Moduls. Vorzugsweise weist das Gehäuseteil 100 zumindest einen Gehäuseteilabschnitt (21, 22) auf, der in einem Aufnahmeabschnitt (31, 34, 35, 40) des Aufnahmeteils 17 aufgenommen ist. Dabei ist das Gehäuseteil 100 erdbar mittels eines mit dem Gehäuseteilabschnitt (21, 22) verbundenen Kabelschuhs (8).

Je nach Art des Elektrogeräts beziehungsweise Moduls, wie Achsmodul, Speichereinheit, Versorgungsmodul oder Rückspeiseeinheit, werden die Anschlussmittel, insbesondere Stromschienen (15, 16) und/oder Laschenteile (10, 11, 13, 14, 18), mit dem Aufnahmeteil 17 verbunden oder nicht. Diese verschiedenartige Bestückung mit Stromschienen (15, 16) und/oder Laschenteilen (10, 11, 13, 14, 18) ermöglicht das Herstellen vieler Varianten, so dass eine Baureihe herstellbar ist mit geringer Anzahl an Teilen.

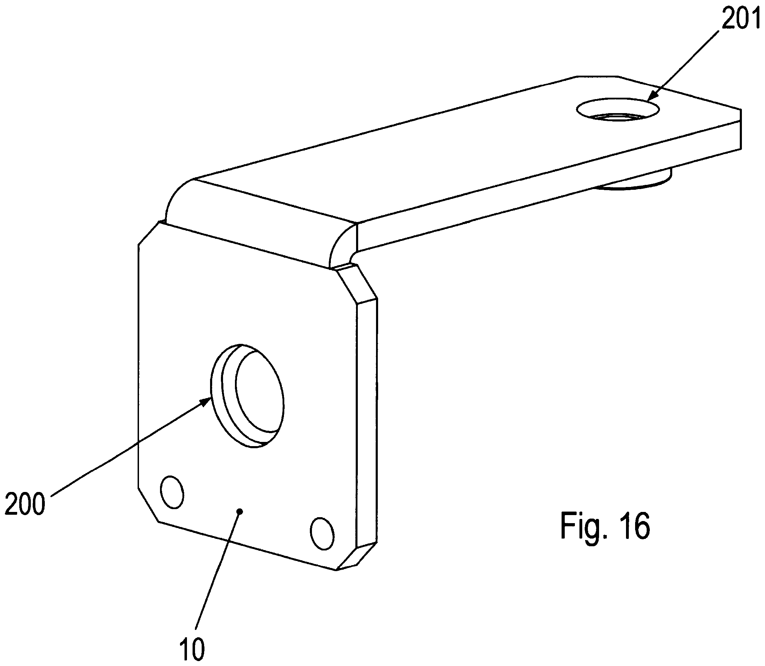

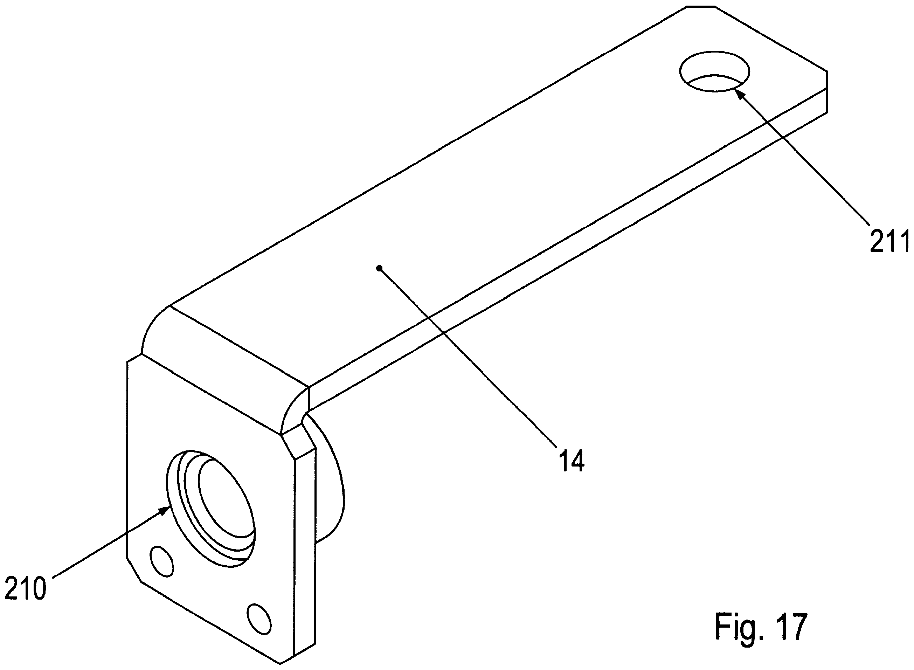

In den Figuren 16 und 17 sind die Laschenteile (10, 11, 13, 14, 18) im Detail dargestellt. Jedes dieser Laschenteile (10, 11, 13, 14, 18) ist als Winkelblech ausgeführt und dabei L-förmig gebogen. Vorzugsweise sind die Laschenteile als Stanzbiegeteile ausgeführt.

Der abgebogene Laschenabschnitt des jeweiligen Laschenteils (10, 11, 13, 14, 18) ist in eine durch das Aufnahmeteil 17 durchgehende Ausnehmung in dem jeweiligen Aufnahmeabschnitt (5, 6, 92, 93, 94) eingeschoben. Jedes der Laschenteile (10, 11, 13, 14, 18) ist lösbar verbunden, insbesondere schraubverbunden, mit dem Aufnahmeteil 17.

Bei Ausführung des Moduls als Versorgungsmodul 1 sind ein erstes, zweites und drittes Laschenteil (10, 11, 13) für eine jeweilige Phase einer Drehstromversorgung vorgesehen.

Das Versorgungsmodul 1 weist einen Gleichrichter auf, der einen Spannungszwischenkreis des Umrichtersystems speist. Das Versorgungsmodul 1 und die Achsmodule (2, 3, 4) weisen also einen einzigen gemeinsamen Spannungszwischenkreis auf. Die drei Phasen der Drehstromversorgung werden dem Gleichrichter zugeführt.

Vorzugsweise ist an einer elektrischen Leitung der Netzversorgung, beispielsweise einem elektrischen Kabel, ein Kabelschuh für jede Phase angeordnet. An der Unterseite der Anschlusseinheit 30 ist eine elektrische Leitung angeschlossen, die zu einer elektrischen und/oder elektronischen Schaltung im Versorgungsmodul 1 führt. Diese elektrische Leitung ist als ein Kabel oder als eine Stromschiene ausgeführt. Somit ist das Laschenteil (10, 11, 13) jeweils als elektrisches Verbindungselement wirksam, welches eine äußere Leitung des Versorgungsmoduls 1 mit einer inneren Leitung des Versorgungsmoduls 1, insbesondere den Eingangsanschlüssen des Gleichrichters, elektrisch leitend verbindet.

Die Ausgangsanschlüsse des Gleichrichters sind mit Stromschienen (15, 16) der Anschlusseinheit 30 des Versorgungsmoduls 1 verbunden zur Verbindung mit weiteren Modulen des Umrichtersystems.

Ein viertes und fünftes Laschenteil (14, 18) sind zur Verbindung des Versorgungsmoduls 1 mit einem Bremswiderstand, insbesondere mittels eines zweiadrigen Verbindungskabels, vorgesehen. Dazu weist das Verbindungskabel zwei Kabelschuhe auf, wobei ein jeweiliger Kabelschuh mit dem vierten oder fünften Laschenteil (14, 18) elektrisch leitend verbunden ist.

Mittels des Bremswiderstandes ist die Spannung im Spannungszwischenkreis bei generatorischem Betrieb des Umrichtersystems reduzierbar, indem elektrische Energie in Wärmeenergie umgewandelt wird.

Jedes Laschenteil (10, 11, 13, 14, 18) weist eine Ausnehmung (200, 210), insbesondere Gewindebohrung auf, in welche eine Schraube einschraubbar ist, deren Schraubenkopf den von außen anliegenden Kabelschuh gegen das jeweilige Laschenteil (10, 11, 13) presst. Ebenso wird die von innen anliegende Leitung schraubverbunden mit dem abgebogenen Laschenabschnitt des jeweiligen Laschenteils (10, 11, 13) mittels einer Ausnehmung (201, 211), insbesondere Gewindebohrung, in dem Laschenabschnitt.

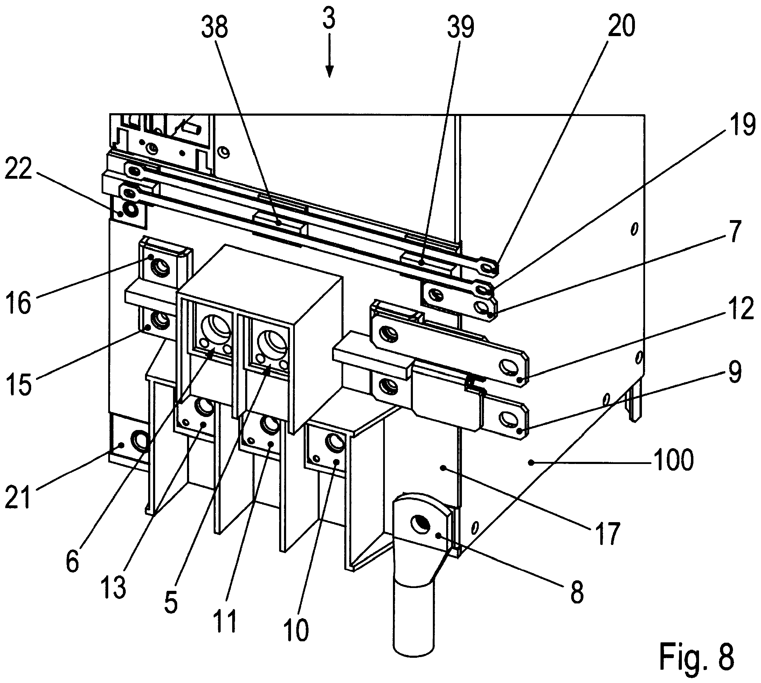

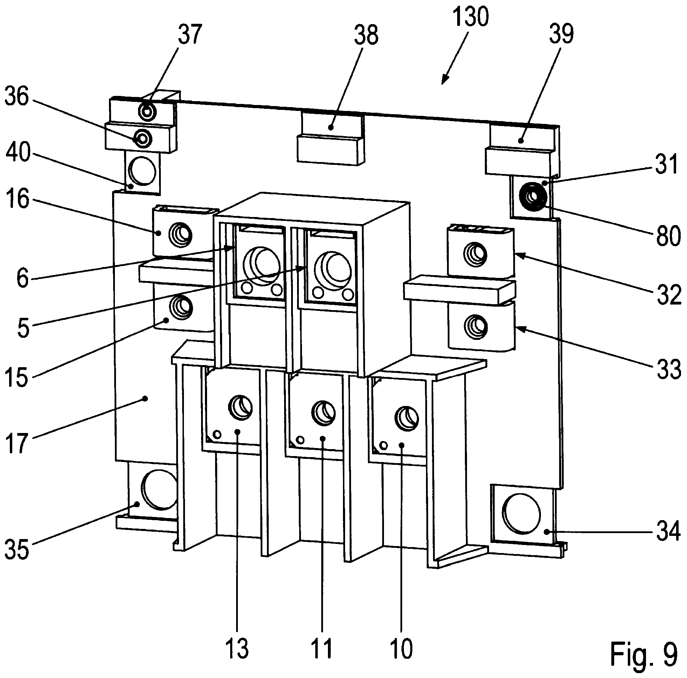

Die Figuren 8 und 9 zeigen die zweite Ausführungsform der Anschlusseinheit 130, die für ein Achsmodul verwendbar ist. Die zweite Ausführungsform der Anschlusseinheit 130 entspricht im Wesentlichen der ersten Ausführungsform der Anschlusseinheit 30 und weist ein gleichartiges Aufnahmeteil 17 auf, wobei die Laschenteile (14, 18) für das Bremsmodul nicht bestückt sind.

Bei Ausführung des Moduls als Achsmodul (2, 3, 4) weist das Modul einen Wechselrichter auf. Der Wechselrichter wird aus dem Spannungszwischenkreis gespeist und wandelt die eingespeiste Gleichspannung in eine dreiphasige Wechselspannung um.

Die Anschlusseinheit 130 des Achsmoduls (2, 3, 4), insbesondere die zweite Anschlusseinheit 130, weist ebenfalls Stromschienen (15, 16) auf zur Verbindung des Eingangs des Wechselrichters mit dem Spannungszwischenkreis, insbesondere dem Ausgang des Gleichrichters des Versorgungsmoduls 1. Dazu sind die Stromschienen (15, 16) der Anschlusseinheit 130 des Achsmoduls (2, 3, 4) elektrisch leitend verbunden mit den Stromschienen (15, 16) der Anschlusseinheit 30 des Versorgungsmoduls 1 mittels Verbindungsschienen (9, 12). Vorzugsweise sind die Verbindungsschienen (9, 12) lösbar verbunden mit den jeweiligen Stromschienen (15, 16).

Die Verbindungschienen (9, 12) überlappen einander zumindest teilweise, wobei zwischen den Verbindungsschienen ein Isoliermittel angeordnet ist.

Das Achsmodul (2, 3, 4) weist im Gegenteil zu dem Versorgungsmodul 1 keinen Bremswiderstand auf. Die Anschlusseinheit 130 des Achsmoduls (2, 3, 4), insbesondere die zweite Anschlusseinheit 130, weist keine Laschenteile (14, 18) zum Anschluss eines Bremswiderstandes auf. Die Aufnahmeabschnitte (5, 6) für die Laschenteile (14, 18) sind beim Achsmodul (2, 3, 4) unbestückt ausgeführt.

Mittels des ersten, zweiten und dritten Laschenteils (10, 11, 13) ist ein von dem Wechselrichter erzeugter dreiphasiger Drehstrom einspeisbar in einen Elektromotor. Dabei wird das erste Laschenteil 10 für die erste Phase, das zweite Laschenteil 11 für die zweite Phase und das dritte Laschenteil 13 für die dritte Phase des Drehstroms verwendet.

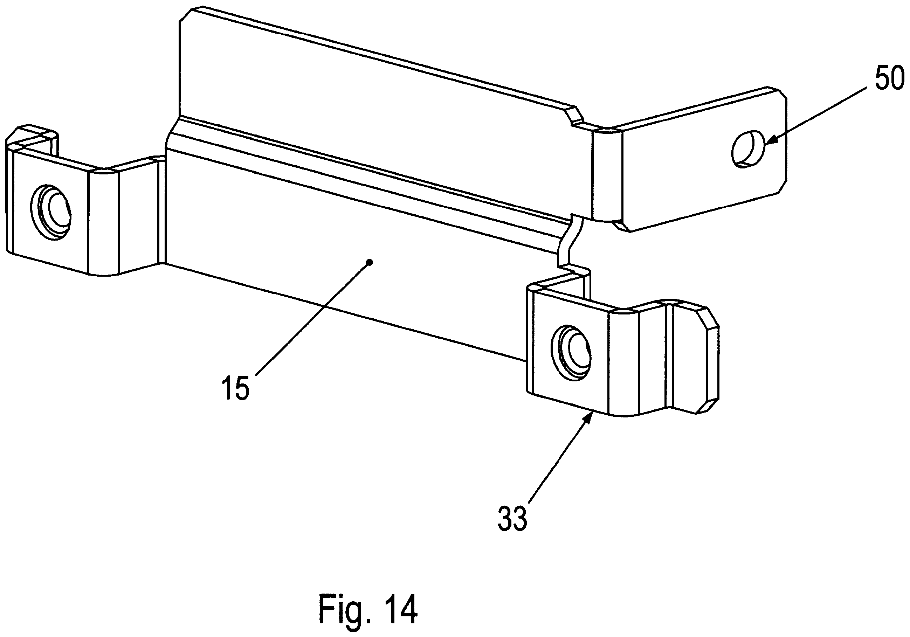

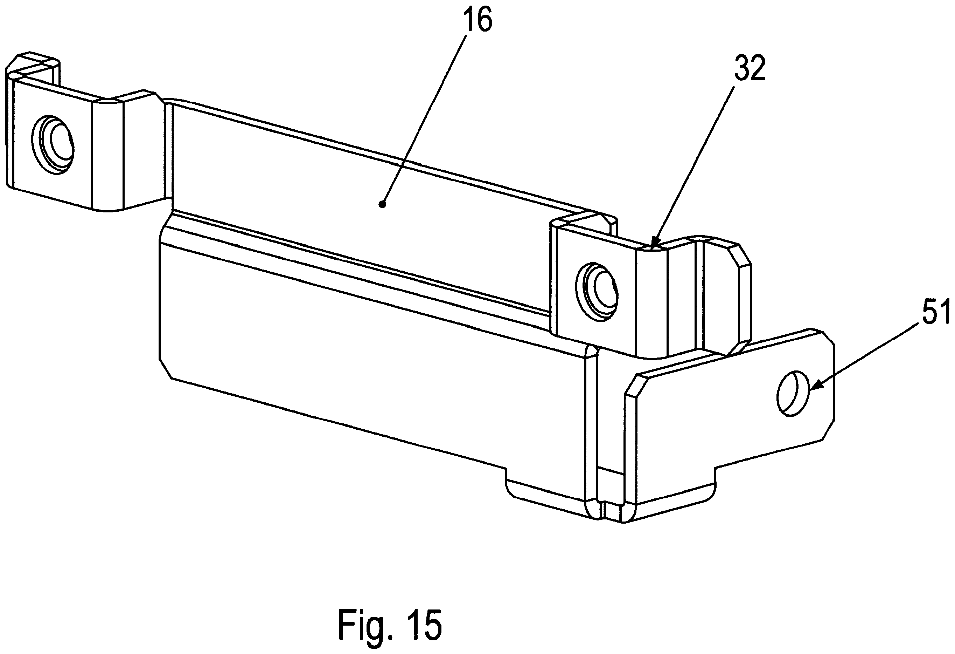

In den Figuren 14 und 15 sind die Stromschienen (15, 16) im Detail dargestellt. Die Stromschienen (15, 16) sind als Stanz-Biegeteile ausgeführt und weisen jeweils zwei zur Oberseite hin hervor gebogene Bereiche, insbesondere Laschenabschnitte (32, 33), auf, die jeweils in eine Ausnehmung (90, 91, 95, 96), insbesondere durchgehende Ausnehmung (90, 91, 95, 96), in dem Aufnahmeteil 17 hineinragen und somit an der Oberseite des Aufnahmeteils 17 herausragen. Diese Bereiche weisen wiederum jeweils eine Ausnehmung, insbesondere Gewindebohrung auf, mit welcher ein einen Kabelschuh gegen die jeweilige Stromschiene (15, 16) drückendes Schraubteil schraubverbindbar ist.

Die Stromschiene (15, 16) weist einen zwischen den Laschenabschnitten (32, 33) angeordneten Verbreiterungsabschnitt auf, von dem aus sich ein Verbindungsabschnitt mit einer Ausnehmung (50, 51) in das Gehäuse des Moduls hinein erstreckt zur Verbindung der Stromschiene (15, 16) mit der Elektronik des Moduls, insbesondere dem Ausgangsanschluss des Gleichrichters des Versorgungsmoduls 1 oder einem Eingangsanschluss des Wechselrichters eines Achsmoduls (2, 3, 4).

In den Figuren 16 und 17 sind die Laschenteile (10, 11, 13, 14, 18) im Detail dargestellt. Jedes dieser Laschenteile (10, 11, 13, 14, 18) ist als Winkelblech ausgeführt und dabei L-förmig gebogen. Vorzugsweise sind die Laschenteile als Stanzbiegeteile ausgeführt.

Der abgebogene Laschenabschnitt des jeweiligen Laschenteils (10, 11, 13, 14, 18) ist in eine durch das Aufnahmeteil 17 durchgehende Ausnehmung in dem jeweiligen Aufnahmeabschnitt (5, 6, 92, 93, 94) eingeschoben. Jedes der Laschenteile (10, 11, 13, 14, 18) ist schraubverbunden mit dem Aufnahmeteil 17. Die Laschenteile (10, 11, 13, 14, 18) sind also formschlüssig und lösbar mit dem jeweiligen Aufnahmeteil 17 verbunden.

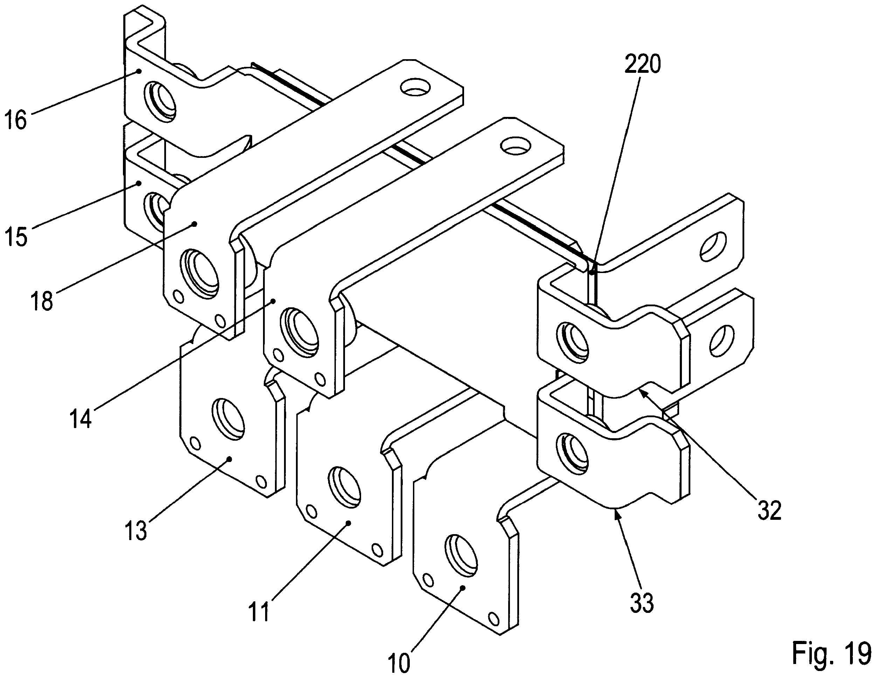

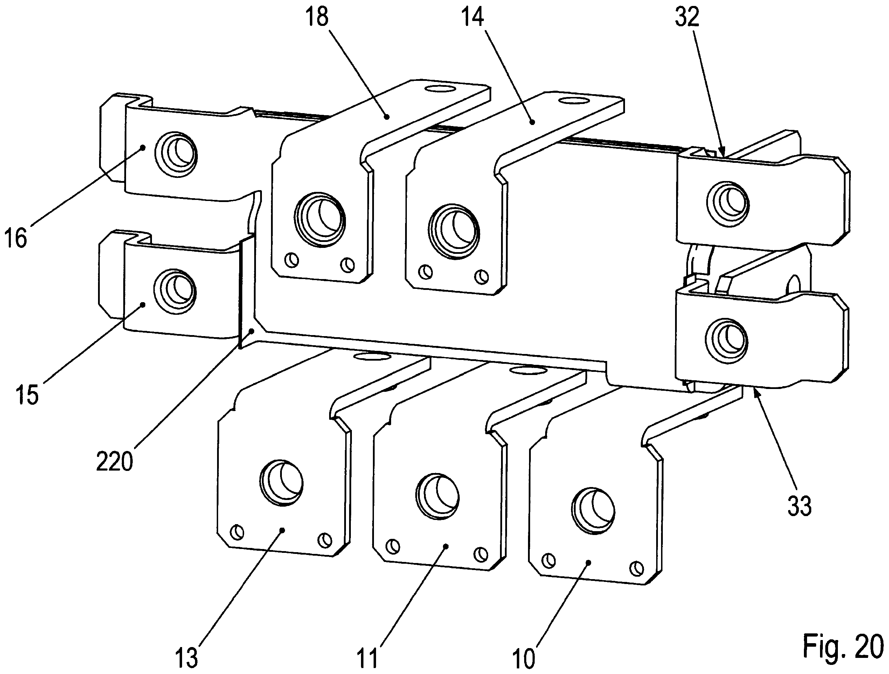

Die Figuren 19 und 20 zeigen die Anordnung der Stromschienen (15, 16) und der Laschenteile (10, 11, 13, 14, 18), wobei das Aufnahmeteil 17 ausgeblendet ist. Die Verbreiterungsabschnitte der Stromschienen (15, 16) überlappen einander. Zwischen den Stromschienen (15, 16) ist ein Isoliermittel 220, insbesondere Isolierfolie, angeordnet, mittels der die erste Stromschiene 15 von der zweiten Stromschiene 16 elektrisch isolierbar ist. Beide Stromschienen (15, 16) berühren das Isoliermittel 220. Vorzugsweise ist das Isoliermittel 220 elastisch verformbar ausgeführt, so dass die Form des Isoliermittels 220 an die Grenzfläche zwischen der ersten Stromschiene 15 und der zweiten Stromschiene 16 anpassbar ist.

Die Stromschienen (15, 16) erstrecken sich im Wesentlichen parallel zueinander. Die Laschenteile (10, 11, 13, 14, 18) erstrecken sich im Wesentlichen parallel zueinander durch das Aufnahmeteil 17 hindurch in das Modul hinein. Die wesentliche Erstreckungsrichtung der Stromschienen (15, 16) ist quer angeordnet zu der wesentliche Erstreckungsrichtung der Laschenteile (10, 11, 13, 14, 18).

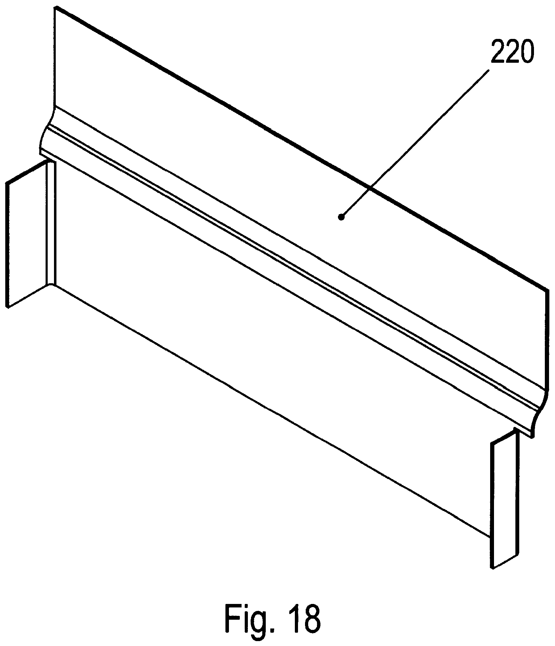

Figur 18 zeigt das Isoliermittel 220 im Detail. Vorzugsweise ist das Isoliermittel 220 elastisch verformbar ausgeführt, so dass die Form des Isoliermittels 220 an die Grenzfläche zwischen der ersten Stromschiene 15 und der zweiten Stromschiene 16 anpassbar ist.

Erfindungsgemäß ist die Anschlusseinheit (30, 130) für verschiedene Elektrogeräte eines Elektrogerätesystems verwendbar, wobei je nach Art des Elektrogerätes eine Nichtbesetzung mit den entsprechenden Anschlussmitteln, insbesondere Laschenteilen (10, 11, 13, 14, 18), erfolgt.

Die Anschlusseinheit (30, 130) ist jeweils von einem nicht dargestellten weiteren Gehäuseteil zumindest teilweise gehäusebildend umgeben. Vorzugsweise ist das weitere Gehäuseteil elektrisch isolierend ausgeführt.

### Bezugszeichenliste

- 1: Versorgungsmodul
- 2: Achsmodul
- 3: Achsmodul
- 4: Achsmodul
- 5: Aufnahmeabschnitt, insbesondere für viertes Laschenteil
- 6: Aufnahmeabschnitt, insbesondere für fünftes Laschenteil
- 7: Verbindungsteil, insbesondere Erdverbindungsteil
- 8: Kabelschuh
- 9: zweite Verbindungsschiene
- 10: erstes Laschenteil, insbesondere Stromschienenlaschenteil für erste Phase
- 11: zweites Laschenteil, insbesondere Stromschienenlaschenteil für zweite Phase
- 12: erste Verbindungsschiene
- 13: drittes Laschenteil, insbesondere Stromschienenlaschenteil für dritte Phase
- 14: viertes Laschenteil, insbesondere Stromschienenlaschenteil für Bremswiderstand
- 15: erste Stromschiene
- 16: zweite Stromschiene
- 17: Aufnahmeteil
- 18: fünftes Laschenteil, insbesondere Stromschienenlaschenteil für Bremswiderstand
- 19: Verbindungsteil, insbesondere für Niederspannungsversorgung
- 20: Verbindungsteil, insbesondere für Niederspannungsversorgung
- 21: Gehäuseteilabschnitt
- 22: Gehäuseteilabschnitt
- 30: Anschlusseinheit
- 31: Aufnahmeabschnitt, insbesondere für Gehäuseteilabschnitt
- 32: Laschenabschnitt
- 33: Laschenabschnitt
- 34: Aufnahmeabschnitt, insbesondere für Gehäuseteilabschnitt
- 35: Aufnahmeabschnitt, insbesondere für Gehäuseteilabschnitt
- 36: Buchse
- 37: Buchse
- 38: Auflagerungsabschnitt
- 39: Auflagerungsabschnitt
- 40: Aufnahmeabschnitt, insbesondere für Gehäuseteilabschnitt
- 50: Ausnehmung
- 51: Ausnehmung
- 60: Deckelteil
- 61: Schraubteil
- 62: Lasche
- 63: Ausnehmung
- 64: Ausnehmung
- 65: Ausnehmung
- 70: Vorsprung
- 80: Buchse
- 90: Aufnahmeabschnitt
- 91: Aufnahmeabschnitt
- 92: Aufnahmeabschnitt
- 93: Aufnahmeabschnitt
- 94: Aufnahmeabschnitt
- 95: Aufnahmeabschnitt
- 96: Aufnahmeabschnitt
- 97: Auflagerungsabschnitt
- 98: Ausnehmung
- 99: Ausnehmung
- 100: Gehäuseteil
- 130: Anschlusseinheit
- 200: Ausnehmung
- 201: Ausnehmung
- 210: Ausnehmung
- 211: Ausnehmung
- 220: Isoliermittel, insbesondere Isolierfolie

## Patentansprüche

1. Elektrogerätesystem aufweisend ein erstes Elektrogerät (1) und ein zweites Elektrogerät (2), Verbindungsschienen (9, 12) und eine erste und zweite Anschlusseinheit (30, 130),
wobei das erste Elektrogerät (1) lösbar mit der ersten Anschlusseinheit (30) verbunden ist, insbesondere mittels eines Schraubteils schraubverbunden,
wobei das zweite Elektrogerät (2) lösbar mit der zweiten Anschlusseinheit (130) verbunden ist, insbesondere mittels eines Schraubteils schraubverbunden,
wobei ein Spannungsausgang des ersten Elektrogerätes (1) mittels der ersten und zweiten Anschlusseinheiten (30, 130) und der Verbindungsschienen (9, 12) mit einem Spannungseingang des zweiten Elektrogeräts elektrisch leitend verbunden ist,
wobei die erste Anschlusseinheit (30) ein erstes Aufnahmeteil (17) aufweist und die zweite Anschlusseinheit (130) ein zweites Aufnahmeteil (17) aufweist,
wobei das erste und zweite Aufnahmeteil (17) jeweils einen ersten Aufnahmeabschnitt (90, 91, 92, 93, 94, 95, 96) und einen zweiten Aufnahmeabschnitt (5, 6) zur Aufnahme von Anschlussmitteln (10, 11, 13, 14, 15, 16, 18) aufweisen,
wobei jeweils ein Anschlussmittel (10, 11, 13, 15, 16), insbesondere eine Stromschiene (15, 16), in dem ersten Aufnahmeabschnitt (90, 91, 92, 93, 94, 95, 96) aufgenommen ist, insbesondere wobei das jeweilige Anschlussmittel lösbar verbunden ist mit dem jeweiligen Aufnahmeteil (17),
wobei in dem zweiten Aufnahmeabschnitt (5, 6) der ersten Anschlusseinheit (30) ein Anschlussmittel (14, 18) aufgenommen ist, insbesondere lösbar verbunden ist mit dem Aufnahmeteil (17),
wobei in dem zweiten Aufnahmeabschnitt (5, 6) der zweiten Anschlusseinheit (130) kein Anschlussmittel aufgenommen ist und
wobei das erste und zweite Aufnahmeteil (17) identisch zueinander sind.

2. Elektrogerätesystem nach Anspruch 1,
**dadurch gekennzeichnet, dass**
das erste Elektrogerät als Versorgungsmodul (1) ausgeführt ist und einen Gleichrichter aufweist,
wobei das zweite Elektrogerät als Achsmodul (2, 3, 4) ausgeführt ist und einen Wechselrichter aufweist,
wobei der Spannungsausgang des Gleichrichters, insbesondere Zwischenkreisspannungsanschluss, mit zwei jeweiligen Anschlussmitteln, insbesondere Stromschienen (15, 16), der ersten Anschlusseinheit (30) elektrisch leitend verbunden ist und der Spannungseingang des Wechselrichters, insbesondere Zwischenkreisspannungsanschluss, mit zwei jeweiligen Anschlussmitteln, insbesondere Stromschienen (15, 16), der zweiten Anschlusseinheit (130) elektrisch leitend verbunden ist,
wobei jeweils ein Anschlussmittel (15, 16) der ersten Anschlusseinheit (30) mit jeweils einem Anschlussmittel (15, 16) der zweiten Anschlusseinheit (130) mittels einer Verbindungsschiene (9, 12) verbunden ist,
insbesondere wobei das Elektrogerätesystem zwei Verbindungschienen (9, 12) und ein zwischen den beiden Verbindungschienen (9, 12) angeordnetes Isoliermittel aufweist, wobei die Verbindungsschienen (9, 12) das Isoliermittel jeweils berühren, insbesondere wobei die Verbindungschienen (9, 12) elektrisch voneinander isoliert angeordnet sind mittels des Isoliermittels.

3. Elektrogerätesystem nach Anspruch 1 oder 2,
**dadurch gekennzeichnet, dass**
die erste Anschlusseinheit (30) drei Anschlussmittel, insbesondere Laschenteile (10, 11, 13), aufweist,
wobei jeweils eine Phase einer Drehstromversorgung mit einem jeweiligen Spannungseingang des Versorgungsmoduls (1) mittels eines jeweiligen Anschlussmittels verbindbar ist.

4. Elektrogerätesystem nach einem der Ansprüche 1 bis 3,
**dadurch gekennzeichnet, dass**
die zweite Anschlusseinheit (130) drei Anschlussmittel, insbesondere Laschenteile (10, 11, 13), aufweist,
wobei jeweils eine Phase der von dem Wechselrichter erzeugten dreiphasigen Wechselspannung mittels jeweils eines Anschlussmittels mit einem jeweiligen Spannungseingang einer Maschine, insbesondere eines Elektromotors, verbindbar ist.

5. Elektrogerätesystem nach einem der Ansprüche 1 bis 4, **dadurch gekennzeichnet, dass**
die Aufnahmeteile (17) jeweils zwei zweite Aufnahmeabschnitte (5, 6) für zwei Anschlussmittel, insbesondere Laschenteile (14, 18), aufweisen,
wobei in den zweiten Aufnahmeabschnitten (5, 6) des ersten Aufnahmeteils (17) die Anschlussmitte (14, 18) aufgenommen sind zur elektrisch leitenden Verbindung mit einem Bremswiderstand des Versorgungsmoduls (1).

6. Elektrogerätesystem nach einem der Ansprüche 1 bis 5, **dadurch gekennzeichnet, dass**
das Elektrogerätesystem zumindest ein Verbindungsteil (19, 20) aufweist,
wobei das Verbindungsteil (19, 20) mittels Buchsen (36, 37), die mit dem jeweiligen Aufnahmeteil (17) stoffschlüssig verbunden sind, das Versorgungsmodul (1) und/oder das Achsmodul (2, 3, 4) mit einer Niederspannungsversorgung elektrisch leitend verbinden kann, und/oder wobei die jeweiligen Niederspannungseingänge des Versorgungsmoduls (1) und des Achsmoduls (2, 3, 4) mittels der Buchsen (36, 37) und des Verbindungsteils (19, 20) elektrisch leitend miteinander verbunden sind.

7. Verfahren zur Herstellung von zwei Varianten einer Anschlusseinheit für ein Elektrogerätesystem nach einem der Ansprüche 1 bis 6, aus einem Baukasten mit folgenden Teilen:
- ein Aufnahmeteil (17),
- ein Deckelteil (60), aufweisend zwei Ausnehmungen (64, 65),
- zwei Stromschienen (15, 16),
- ein Isoliermittel (220) und
- zumindest ein Laschenteil (10, 11, 13, 14, 18),
wobei das Aufnahmeteil (17) zumindest einen ersten Aufnahmeabschnitt (92, 93, 94) und einen zweiten Aufnahmeabschnitt (5, 6) zur Aufnahme von dem zumindest einen Laschenteil (10, 11, 13, 14, 18) und Aufnahmeabschnitte (90, 91, 95, 96), insbesondere Ausnehmungen, für die Stromschienen (15, 16) aufweist,
wobei zur Herstellung einer ersten Variante der Anschlusseinheit (130):
- in einem ersten Verfahrensschritt das Isoliermittel (220) zwischen den Stromschienen (15, 16) angeordnet, insbesondere formschlüssig verbunden, wird, so dass die Stromschienen (15, 16) elektrisch voneinander isoliert werden und aus den Stromschienen (15, 16) und dem Isoliermittel (220) eine vorkomplettierte Einheit gebildet wird,
- in einem zweiten Verfahrensschritt die vorkomplettierte Einheit in das Deckelteil (60) eingelegt wird, wobei ein jeweiliger Laschenabschnitt einer Stromschiene (15, 16) der Einheit durch eine jeweilige Ausnehmung (64, 65) geführt wird,
- in einem dritten Verfahrensschritt das Deckelteil (60) lösbar mit dem Aufnahmeteil (17) verbunden wird, insbesondere mittels eines Schraubteils (61) schraubverbunden, und
- in einem vierten Verfahrensschritt das Laschenteil (10, 11, 13) in den ersten Aufnahmeabschnitt (92, 93, 94) eingeführt wird und kraft- und/oder formschlüssig mit dem Aufnahmeteil (17) verbunden wird, insbesondere mittels eines Schraubteils schraubverbunden,
wobei zur Herstellung einer zweiten Variante der Anschlusseinheit (30) zusätzlich zu dem ersten bis vierten Verfahrensschritt, in einem fünften Verfahrensschritt ein weiteres Laschenteil (14, 18) in den zweiten Aufnahmeabschnitt (5, 6) eingeführt wird und kraft- und/oder formschlüssig mit dem Aufnahmeteil (17) verbunden wird, insbesondere mittels eines Schraubteils schraubverbunden,
wobei das erste und zweite Aufnahmeteil (17) identisch zueinander sind.

## Claims

1. An electrical device system having a first electrical device (1) and a second electrical device (2), connecting rails (9, 12) and a first and second terminal unit (30, 130),
wherein the first electrical device (1) is connected detachably to the first terminal unit (30),
in particular screw-connected by means of a screwing part,
wherein the second electrical device (2) is connected detachably to the second terminal unit (130),
in particular screw-connected by means of a screwing part,
wherein a voltage output of the first electrical device (1) is connected in electrically conductive manner by means of the first and second terminal units (30, 130) and the connecting rails (9, 12) to a voltage input of the second electrical device,
wherein the first terminal unit (30) has a first receiving part (17) and the second terminal unit (130) has a second receiving part (17),
wherein the first and second receiving parts (17) in each case have a first receiving portion (90, 91, 92, 93, 94, 95, 96) and a second receiving portion (5, 6) for receiving terminal means (10, 11, 13, 14, 15, 16, 18),
wherein in each case one terminal means (10, 11, 13, 15, 16), in particular a conductor bar (15, 16), is received in the first receiving portion (90, 91, 92, 93, 94, 95, 96), in particular wherein the respective terminal means is detachably connected to the respective receiving part (17),
wherein a terminal means (14, 18) is received in the second receiving portion (5, 6) of the first terminal unit (30), in particular is connected detachably to the receiving part (17),
wherein no terminal means is received in the second receiving portion (5, 6) of the second terminal unit (130) and
wherein the first and second receiving parts (17) are identical to each other.

2. An electrical device system according to Claim 1,
**characterised in that**
the first electrical device is embodied as a supply module (1) and has a rectifier,
the second electrical device being embodied as an axis module (2, 3, 4) and having an inverter,
the voltage output of the rectifier, in particular DC-link voltage terminal, being connected in electrically conductive manner to two respective terminal means, in particular conductor bars (15, 16), of the first terminal unit (30) and the voltage input of the inverter, in particular DC-link voltage terminal, being connected in electrically conductive manner to two respective terminal means, in particular conductor bars (15, 16), of the second terminal unit (130),
with in each case one terminal means (15, 16) of the first terminal unit (30) being connected to in each case one terminal means (15, 16) of the second terminal unit (130) by means of a connecting rail (9, 12),
in particular with the electrical device system having two connecting rails (9, 12) and an insulating means arranged between the two connecting rails (9, 12), with the connecting rails (9, 12) touching the insulating means in each case, in particular with the connecting rails (9, 12) being arranged electrically insulated from each other by means of the insulating means.

3. An electrical device system according to Claim 1 or 2,
**characterised in that**
the first terminal unit (30) has three terminal means, in particular lug parts (10, 11, 13),
with in each case one phase of a three-phase supply being able to be connected to a respective voltage input of the supply module (1) by means of a respective terminal means.

4. An electrical device system according to one of Claims 1 to 3,
**characterised in that**
the second terminal unit (130) has three terminal means, in particular lug parts (10, 11, 13),
wherein in each case one phase of the three-phase alternating voltage generated by the inverter can be connected by means of one terminal means in each case to a respective voltage input of a machine, in particular an electric motor.

5. An electrical device system according to one of Claims 1 to 4,
**characterised in that**
the receiving parts (17) in each case have two second receiving portions (5, 6) for two terminal means, in particular lug parts (14, 18),
wherein the terminal means (14, 18) are received in the second receiving portions (5, 6) of the first receiving part (17) for electrically conductive connection with a braking resistor of the supply module (1).

6. An electrical device system according to one of Claims 1 to 5,
**characterised in that**
the electrical device system has at least one connecting part (19, 20),
the connecting part (19, 20) being able to connect the supply module (1) and/or the axis module (2, 3, 4) to a low-voltage supply in electrically conductive manner by means of sockets (36, 37) which are connected to the respective receiving part (17) by a material-formed bond,
and/or the respective low-voltage inputs of the supply module (1) and of the axis module (2, 3, 4) being connected together in electrically conductive manner by means of the sockets (36, 37) and the connecting part (19, 20).

7. A method for producing two variants of a terminal unit for an electrical device system according to one of Claims 1 to 6, from a modular system with the following parts:
- a receiving part (17),
- a cover part (60), having two cutouts (64, 65),
- two conductor bars (15, 16),
- an insulating means (220), and
- at least one lug part (10, 11, 13, 14, 18),
wherein the receiving part (17) has at least a first receiving portion (92, 93, 94) and a second receiving portion (5, 6) for receiving the at least one lug part (10, 11, 13, 14, 18) and receiving portions (90, 91, 95, 96), in particular cutouts, for the conductor bars (15, 16),
wherein to produce a first variant of the terminal unit (130):
- in a first method step the insulating means (220) is arranged between the conductor bars (15, 16), in particular is connected in a positively locking manner, so that the conductor bars (15, 16) are electrically insulated from each other and a precompleted unit is formed from the conductor bars (15, 16) and the insulating means (220),
- in a second method step the precompleted unit is placed in the cover part (60), wherein a respective lug portion of a conductor bar (15, 16) of the unit is guided through a respective cutout (64, 65),
- in a third method step the cover part (60) is connected detachably to the receiving part (17), in particular screw-connected by means of a screwing part (61), and
- in a fourth method step the lug part (10, 11, 13) is introduced into the first receiving portion (92, 93, 94) and connected in a non-positively and/or positively locking manner to the receiving part (17), in particular screw-connected by means of a screwing part,
wherein for producing a second variant of the terminal unit (30), in addition to the first to fourth method step, in a fifth method step a further lug part (14, 18) is introduced into the second receiving portion (5, 6) and is connected in a non-positively and/or positively locking manner to the receiving part (17), in particular screw-connected by means of a screwing part,
wherein the first and second receiving part (17) are identical to each other.

## Revendications

1. Système d'appareils électriques présentant un premier appareil électrique (1) et un deuxième appareil électrique (2), des rails de liaison (9, 12) et une première et une deuxième unité de connexion (30, 130),
dans lequel le premier appareil électrique (1) est relié de manière amovible, en particulier relié par vissage au moyen d'une partie filetée, à la première unité de connexion (30),
dans lequel le deuxième appareil électrique (2) est relié de manière amovible, en particulier relié par vissage au moyen d'une partie filetée, à la deuxième unité de connexion (130),
dans lequel une sortie de tension du premier appareil électrique (1) est reliée de manière électriquement conductrice à une entrée de tension du deuxième appareil électrique au moyen des première et deuxième unités de connexion (30, 130) et des rails de liaison (9, 12),
dans lequel la première unité de connexion (30) présente une première partie de réception (17) et la deuxième unité de connexion (130) présente une deuxième partie de réception (17),
dans lequel les première et deuxième parties de réception (17) présentent chacune une première section de réception (90, 91, 92, 93, 94, 95, 96) et une deuxième section de réception (5, 6) pour recevoir des moyens de connexion (10, 11, 13, 14, 15, 16, 18),
dans lequel un moyen de connexion respectif (10, 11, 13, 15, 16), en particulier une barre conductrice (15, 16), est reçu dans la première section de réception (90, 91, 92, 93, 94, 95, 96), en particulier dans lequel le moyen de connexion respectif est relié de manière amovible à la partie de réception respective (17),
dans lequel un moyen de connexion (14, 18) est reçu dans la deuxième section de réception (5, 6) de la première unité de connexion (30), en particulier est relié de manière amovible à la partie de réception (17),
dans lequel aucun moyen de connexion n'est reçu dans la deuxième section de réception (5, 6) de la deuxième unité de connexion (130) et
dans lequel la première et la deuxième partie de réception (17) sont identiques l'une à l'autre.

2. Système d'appareils électriques selon la revendication 1,
**caractérisé en ce que**
le premier appareil électrique est réalisé sous la forme d'un module d'alimentation (1) et présente un redresseur,
dans lequel le deuxième appareil électrique est réalisé sous la forme d'un module d'axe (2, 3, 4) et présente un onduleur,
dans lequel la sortie de tension du redresseur, en particulier la connexion de tension de circuit intermédiaire, est reliée de manière électriquement conductrice à deux moyens de connexion respectifs, en particulier des barres conductrices (15, 16), de la première unité de connexion (30), et l'entrée de tension de l'onduleur, en particulier la connexion de tension de circuit intermédiaire, est reliée de manière électriquement conductrice à deux moyens de connexion respectifs, en particulier des barres conductrices (15, 16), de la deuxième unité de connexion (130),
dans lequel un moyen de connexion respectif (15, 16) de la première unité de connexion (30) est relié à un moyen de connexion respectif (15, 16) de la deuxième unité de connexion (130) au moyen d'un rail de liaison (9, 12),
en particulier dans lequel le système d'appareils électriques présente deux rails de liaison (9, 12) et un moyen isolant disposé entre les deux rails de liaison (9, 12), dans lequel les rails de liaison (9, 12) sont chacun en contact avec le moyen isolant, en particulier dans lequel les rails de liaison (9, 12) sont disposés de manière électriquement isolée l'un par rapport à l'autre au moyen du moyen isolant.

3. Système d'appareils électriques selon la revendication 1 ou 2,
**caractérisé en ce que**
la première unité de connexion (30) présente trois moyens de connexion, en particulier des parties languette (10, 11, 13),
dans lequel une phase respective d'une alimentation triphasée peut être reliée à une entrée de tension respective du module d'alimentation (1) au moyen d'un moyen de connexion respectif.

4. Système d'appareils électriques selon l'une des revendications 1 à 3,
**caractérisé en ce que**
la deuxième unité de connexion (130) présente trois moyens de connexion, en particulier des parties languette (10, 11, 13),
dans lequel une phase respective de la tension alternative triphasée générée par l'onduleur peut être reliée à une entrée de tension respective d'une machine, en particulier d'un moteur électrique, au moyen d'un moyen de connexion respectif.

5. Système d'appareils électriques selon l'une des revendications 1 à 4,
**caractérisé en ce que**
les parties de réception (17) présentent chacune deux deuxièmes sections de réception (5, 6) pour deux moyens de connexion, en particulier des parties languette (14, 18), dans lequel les deuxièmes sections de réception (5, 6) de la première partie de réception (17) reçoivent les moyens de connexion (14, 18) pour la liaison électriquement conductrice à une résistance de freinage du module d'alimentation (1).

6. Système d'appareils électriques selon l'une des revendications 1 à 5,
**caractérisé en ce que**
le système d'appareils électriques présente au moins une partie de liaison (19, 20), dans lequel la partie de liaison (19, 20) peut relier de manière électriquement conductrice le module d'alimentation (1) et/ou le module d'axe (2, 3, 4) à une alimentation basse tension au moyen de douilles (36, 37) qui sont reliées par liaison de matière à la partie de réception respective (17),
et/ou dans lequel les entrées basse tension respectives du module d'alimentation (1) et du module d'axe (2, 3, 4) sont reliées entre elles de manière électriquement conductrice au moyen des douilles (36, 37) et de la partie de liaison (19, 20).

7. Procédé de fabrication de deux variantes d'une unité de connexion pour un système d'appareils électriques selon l'une des revendications 1 à 6, à partir d'un kit de construction comprenant les parties suivantes :
- une partie de réception (17),
- une partie couvercle (60), présentant deux évidements (64, 65),
- deux barres conductrices (15, 16),
- un moyen isolant (220) et
- au moins une partie languette (10, 11, 13, 14, 18),
dans lequel la partie de réception (17) présente au moins une première section de réception (92, 93, 94) et une deuxième section de réception (5, 6) pour recevoir ladite au moins une partie languette (10, 11, 13, 14, 18) et des sections de réception (90, 91, 95, 96), en particulier des évidements, pour les barres conductrices (15, 16),
dans lequel, pour fabriquer une première variante de l'unité de connexion (130) :
- dans une première étape du procédé, le moyen isolant (220) est disposé, en particulier relié par complémentarité de forme, entre les barres conductrices (15, 16) de telle sorte que les barres conductrices (15, 16) soient isolés électriquement l'une de l'autre et qu'une unité précomplétée soit formée à partir des barres conductrices (15, 16) et du moyen isolant (220),
- dans une deuxième étape du procédé, l'unité précomplétée est insérée dans la partie couvercle (60), une section languette respective d'une barre conductrice (15, 16) de l'unité étant guidée à travers un évidement respectif (64, 65),
- dans une troisième étape du procédé, la partie couvercle (60) est reliée de manière amovible, en particulier reliée par vissage au moyen d'une partie filetée (61), à la partie de réception (17) et
- dans une quatrième étape du procédé, la partie languette (10, 11, 13) est introduite dans la première section de réception (92, 93, 94) et reliée par force et/ou par complémentarité de forme, en particulier reliée par vissage au moyen d'une partie filetée, à la partie de réception (17),
dans lequel, pour fabriquer une deuxième variante de l'unité de connexion (30), en plus des première à quatrième étapes du procédé, dans une cinquième étape du procédé, une autre partie languette (14, 18) est introduite dans la deuxième section de réception (5, 6) et reliée par force et/ou par complémentarité de forme, en particulier reliée par vissage au moyen d'une partie filetée, à la partie de réception (17),
dans lequel la première et la deuxième partie de réception (17) sont identiques l'une à l'autre.
